# EUROPEAN PATENT APPLICATION

(11) **EP 3 361 840 A1**
(43) Date of publication of application: **15.08.2018**
(21) Application number: 18000292.5
(22) Date of filing: 07.09.2012
(51) Int. Cl.: H05K 3/02, H01L 31/05, B23K 26/364, H05K 3/38, H05K 1/03

(54) **LASER PATTERNING OF PHOTOVOLTAIC BACKSHEET**

(30) Priority: 03.02.2012 US 201261594621 P
(62) Divisional of application: 12773430.9
(71) Applicant: AVERY DENNISON CORPORATION, Pasadena, CA 91103 3596 (US)
(72) Inventor: Kian, Kourosh, Pasadena, CA 91103-3596 (US); Woznic, Frank B., Pasadena, CA 91103-3596 (US); Zajaczkowski, Michael, Pasadena, CA 91103-3596 (US); Ferguson, Scott Wayne, Pasadena, CA 91103-3596 (US); Ross, Michael, Pasadena, CA 91103-3596 (US)
(74) Representative: Müller-Boré & Partner Patentanwälte PartG mbB

(57) **Abstract**

One aspect of the invention relates to a sheet assembly comprising:
a carrier substrate (210);
a conductive metal layer (220); and
an adhesive layer (230) configured to bond the conductive metal layer (220) with the carrier substrate (210), wherein the adhesive layer comprises one or more additives.

## Description

### CROSS REFERENCES TO RELATED APPLICATION

The present application claims the benefit of U.S. Provisional Patent Application No. 61/594,621 filed February 3, 2012, which is incorporated herein by reference in its entirety.

### FIELD

The present subject matter relates to methods and processes for producing a conductive pattern from a laminated foil of copper or aluminum. More particularly, the present subject matter relates to backsheet assemblies for back contact photovoltaic modules and methods of making such assemblies using laser patterning. Furthermore, the present subject matter relates to sheet assemblies with conductive patterns and methods for producing such sheet assemblies that may be used in manufacturing intricately formed circuits, antennas, cells and other specialized applications utilizing metal conductors.

### BACKGROUND

A new type of photovoltaic (PV) module includes various silicon wafers that are electrically connected to a conductive backsheet or member. Unlike traditional designs, this type of photovoltaic cell employs laser drilled vias connecting a front surface carrier collector junction to an electrode grid on the surface of the backsheet. Therefore, back contact silicon cells use only coplanar contacts on the surface of the backsheet (as described in US Patents 5,468,652 and 5,951,786, both to Gee) and avoid the difficulty in making a front to back lead attachment. This coplanar connection allows all the cells in a photovoltaic module to be electrically connected in a single step. Collections of these cells are referred to as a monolithic module assembly (MMA).

The electrical circuitry and electrodes, which form functioning circuitry on the backsheet can be made of any conductive elements, with copper and aluminum being the preferred materials due to their relatively high electrical conductivity, low cost, and availability.

To create the circuitry on the backsheet, conventional industrial processes typically start with a foil laminate in which a conductive metal foil is laminated with a carrier. The conductive foil is then patterned through the use of chemical etching. Chemical etch can be a cumbersome process that is becoming increasingly less available in the US and many other countries. Facilities for performing these processes are now located mainly in Asia.

Laser patterning has been contemplated in recent years. However, protecting the carrier sheet under the metal foil from being damaged by the laser presents a formidable technical challenge. Accordingly, a need exists for a method that utilizes laser patterning which addresses the previously noted objectives and which provides an economically feasible and environmentally friendly process that can be implemented anywhere.

### SUMMARY

The difficulties and drawbacks associated with previously known systems and methods are addressed in the present methods, assemblies, and devices.

In one aspect, a method of forming a flexible circuit using a laser is provided. The method comprises providing a metal foil laminate in which a metal foil is laminated on a carrier. The method also comprises patterning the metal foil using a laser to form an electric circuit without damaging the carrier.

In another aspect, another method of forming a flexible circuit using a laser is provided. The method comprises providing a metal foil laminate in which a metal foil is laminated on a carrier. The method also comprises selecting a laser and a set of operating parameters such that the patterning process does not cause damage to the carrier. The method also comprises patterning the metal foil using the selected laser to create a pattern suitable for forming an electric circuit with a minimum kerf width.

In still other aspects, photovoltaic conductive backsheets are provided which are formed by the noted methods.

And, in yet another aspect, photovoltaic modules are provided which include backsheets formed by the noted methods.

In still a further aspect, a system is provided which is configured for forming a flexible circuit from a metal foil laminate using a laser. The system comprises a laser source and a roll of metal foil laminate. The metal foil laminate includes a metal foil disposed on a carrier. The laser source is configured to operate at a set of operating parameters including beam size, beam shape, beam intensity profile, wavelength, power, pulse energy, frequency, speed and combinations thereof such that the circuit is formed at a speed of at least 400 mm/s and preferably more than 1.2 m/s and more preferably at 2 m/s and the carrier remains intact through the formation of the circuit.

As will be realized, the subject matter is capable of other and different embodiments and its several details are capable of modifications in various respects, all without departing from the subject matter. Accordingly, the drawings and description are to be regarded as illustrative and not restrictive.

### BRIEF DESCRIPTION OF THE DRAWINGS

These, as well as other objects and advantages of this subject matter, will be more completely understood and appreciated by referring to the following more detailed description of the presently preferred exemplary embodiments of the subject matter in conjunction with the accompanying drawings, of which:
Figure 1A is a planar schematic view of a foil laminate before patterning.
Figure 1B is a planar schematic view of a foil laminate patterned for a single module circuit.
Figure 1C is a planar schematic view of a foil laminate patterned for a multiple module circuit.
Figure 2 is a schematic cross sectional view of a preferred embodiment sheet assembly in accordance with the present subject matter.
Figure 3 schematically depicts a preferred embodiment process for manufacturing a sheet assembly in accordance with the present subject matter.
Figure 4 schematically depicts another preferred embodiment process for manufacturing a sheet assembly in accordance with the present subject matter.
Figure 5 illustrates interaction of a laser beam with a plastic material.
Figure 6 illustrates the absorbance for a PET film at a spectrum of wavelengths.
Figure 7 represents the reflectance of a PET film with a fluorinated coating on a backside of the film.
Figure 8 is a graph illustrating the reflectivity of various metals.
Figure 9A are photographs of a square top hat and gaussian beam spots.
Figure 9B is a graph of a square top hat profile with intensity in both directions.
Figure 10A is a photograph showing fine focusing of square fiber delivery cable.
Figure 10B is a detailed photograph of the center three lines of Figure 10A.
Figure 10C is a detailed photograph of round fiber delivery cable.
Figure 10D is a detailed photograph of the center three lines of Figure 10C.
Figure 11A are micrographs of a copper foil after ablation by an infrared laser.
Figure 11B are micrographs of a copper foil after ablation by a green laser.
Figures 12A and 12B are schematic views of a fixed beam focusing assembly used in various evaluations described herein.
Figure 13A is a front elevational view of an infrared laser with fixed beam focusing integrated into a system described herein.
Figure 13B is a schematic perspective view of the system depicted in Figure 13A.
Figure 14 is a photograph of a single panel patterned by a method using laser ablation in accordance with the present subject matter.
Figure 15A is a top view of an SEM image of a high speed ablation on 25 µm copper.
Figure 15B is an SEM cross section of the image in Figure 15A.
Figure 16A is a top view of an SEM image of a high speed ablation on 32 µm copper.
Figure 16B is an SEM cross section of the image in Figure 16A.
Figure 17A is a top view of an SEM image of a sample cut from within a contour.
Figure 17B is an SEM cross section of the image in Figure 17A.
Figure 18 are micrographs showing the effects of changing an assist gas from air to argon in an evaluation described herein.
Figure 19 are micrographs showing the effects of changing the assist gas from air to argon in another evaluation described herein.
Figure 20 are micrographs showing the results of beneficial system settings for foil thicknesses of 35 µm (left micrograph) and 25 µm (right micrograph).
Figure 21A is a micrograph showing the results of ablation trials using a round fiber at high speed.
Figure 21B are micrographs showing the results of ablation trials using two different settings of a round fiber at lower speeds.

### DETAILED DESCRIPTION OF THE EMBODIMENTS

The apparatuses and methods disclosed herein are described in detail by way of examples and with reference to the figures. Unless otherwise specified, like numbers in the figures indicate references to the same, similar, or corresponding elements throughout the figures. It will be appreciated that modifications to disclosed and described examples, arrangements, configurations, components, elements, apparatuses, methods, materials, etc. can be made and may be desired for a specific application. In this disclosure, any identification of specific shapes, materials, techniques, arrangements, etc. are either related to a specific example presented or are merely a general description of such a shape, material, technique, arrangement, etc. Identifications of specific details or examples are not intended to be, and should not be, construed as mandatory or limiting unless specifically designated as such.

Generally, the present subject matter provides a method of forming a sheet assembly having patterned conductive metal foil. The method comprises providing a carrier and depositing an adhesive on the carrier, followed by laminating a conductive metal foil on the layer of adhesive. The method further comprises patterning the conductive metal foil using a laser according to a first designated pattern design. Optionally, the method also comprises depositing an interlayer dielectric (ILD) on the conductive metal foil laminate according to a second designated pattern design. Optionally, the method further comprises depositing a silver layer on the conductive metal foil that is not covered by the interlayer dielectric according to the second designated pattern design. It is also contemplated that instead of, or in addition to, depositing a silver layer, layer(s) of other materials can be deposited such as gold, tin, zinc, alloys thereof, and organic solderability preservative (OSP).

The present subject matter also includes removing or stripping off at least a portion of the conductive metal foil according to the first designated pattern design, after the patterning step. In certain processes it is also possible to remove or strip off at least a portion of the conductive metal foil before the patterning step.

Additionally, the present subject matter includes selecting a two stage cure adhesive, e.g. having a first stage A cure and a second stage B cure, before depositing an adhesive on the carrier step. And the subject matter may further include conducting the stage A curing of the adhesive before or after the laminating step. Also the subject matter may further comprise conducting the stage B curing of the adhesive after the stripping step. Conducting the stage B curing of the adhesive can also be performed after the laser ablation step.

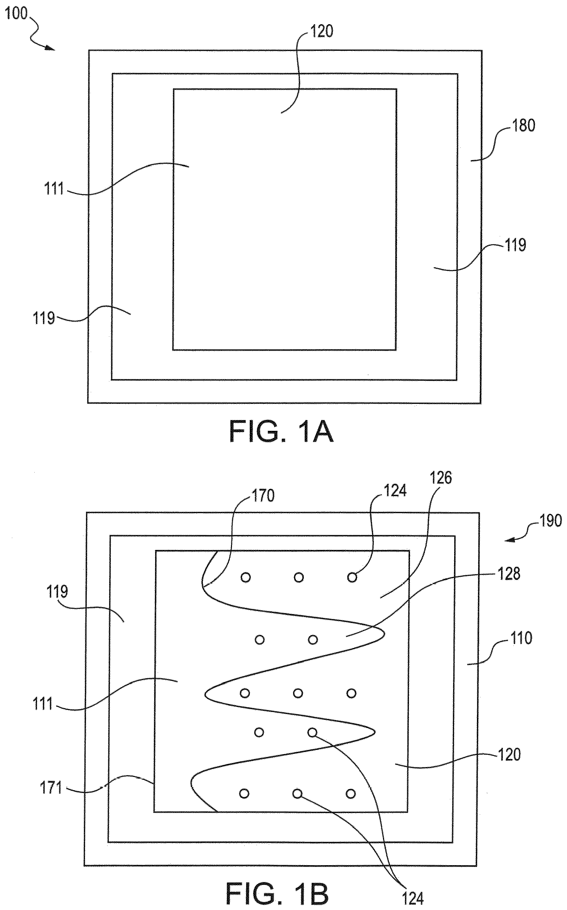

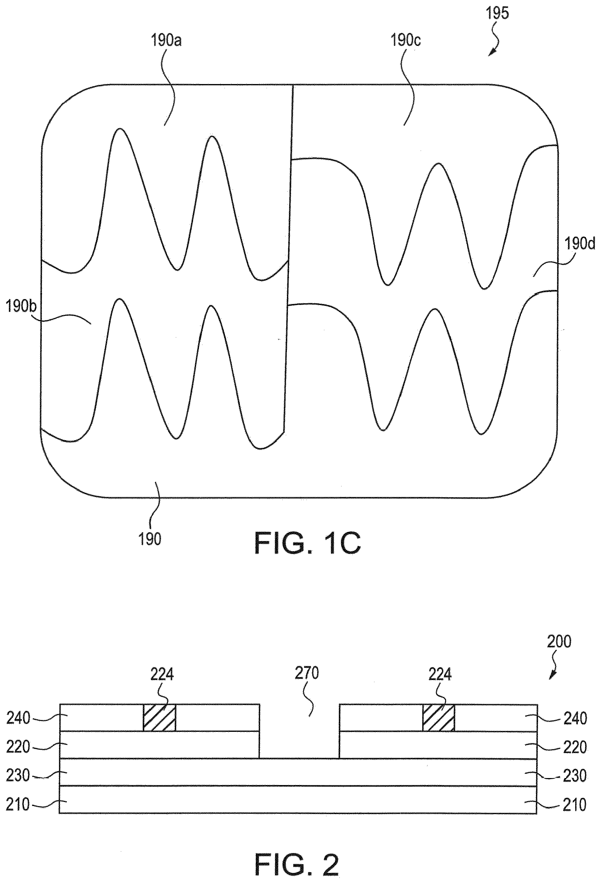

Figures 1A, 1B, and 1C are planar schematic views of a foil laminate before and after laser patterning. Figure 1A illustrates a foil laminate 100 before being laser patterned. The foil laminate includes a metal foil 120 bonded to a carrier 180. The metal foil 120 can be the same size as the carrier 180, or relatively smaller than carrier 180, in which case, an excess area of carrier 119, free of metal foil, is also shown on the planar view of the laminate. The size of the foil area can be equal or substantially equal to the required size for forming the circuitry, or may be relatively larger than the required size for forming the circuitry. The area required for forming the circuitry is designated with a number 111.

Figure 1B is a planar view of a conductive backsheet 190 as a result of the laminate being patterned. A metal-free area 170 is formed on the foil 120 according to a first predetermined design pattern for the circuitry, which separates the foil into two electrically unconnected areas 126 and 128. The metal-free area 170 functions as electrical insulation for disconnecting or electrically separating area 126 from area 128. The particular configuration of the metal-free area 170 can be any configuration or shape that is suitable to avoid electrical communication, i.e., shortage, between the separated metal foils, and provide suitable connections with the silicon cells to complete the circuitry. When the original size of the foil is larger than the required size for forming the circuitry, a second separation line 171 is preferably also formed to define the area required for forming the circuitry. The excess foil within area 119 is preferably stripped off the carrier. In order to form a complete circuit when silicon cells with multiple contacting pads are connected with the patterned foil, electrodes 124 are formed on the patterned foil at locations corresponding to the contacting pads, which are optional. The electrodes can be formed by any suitable method, for example, by depositing silver on the locations for the electrodes. To avoid electrical shortage between the metallic foil and the silicon cell an optional insulating layer can be deposited over the foil surface to cover the foil areas except for the locations of the electrodes 124.

In making a solar module, silicon cells will be in contact with the patterned conductive foil through the electrodes 124. An encapsulating layer will form a sealed space to enclose the silicon cells and the conductive foil by bonding with the foil laminate at peripheral end regions or along a perimeter. Foil within area 119 can be stripped off to make the bonding easier and more durable, and to create electrical isolation between the current carrying conductor and the frame of the solar module.

Figure 1C is a planar view of a conductive panel 195 with five conductive areas. The patterns formed by the laser processes described herein, connect the four solar cells together in parallel or series and conduct the generated electrical power to external connections. Each conductive area, depicted as 190a, 190b, 190c, 190d and 190e (the bottom zone), is separated or isolated from the other conductive areas by a metal-free area, as previously described.

Figure 2 provides an exemplary cross-sectional view of a preferred embodiment sheet assembly with patterned conductive metal foils. The sheet assembly 200 includes a carrier substrate 210, a laminate adhesive layer 230, a patterned conductive metal layer 220 with one or more disconnected areas provided by a metal-free area 270 that separates the metal areas, an optional silver (Ag) layer 224 on the locations or regions corresponding to electrodes, and a dielectric layer 240 that covers the metal layer 220 surface in remaining regions, i.e., the regions of metal layer which do not correspond to locations of electrodes. The adhesive layer 230 can either remain or be removed. Preferably, the adhesive layer 230 remains and is not etched with the metal layer 220. The dielectric layer is generally referred to herein as an interlayer dielectric (ILD). To further improve conductivity and stability of the circuitry, additional layers can be deposited over the electrodes and the foil surface. US provisional patent application 61/451,661 describes such processes and is incorporated herein by reference in its entirety.

The carrier substrate 210 provides mechanical strength and protection to the sheet assemblies. The carrier substrate 210 also provides mechanical and dielectric protection to the finished solar module. Examples of materials for the substrate include, but are not limited to, polyester films, polyethylene terephthalate films, polyimide films, polyamide (nylon) films, poly(ethylene naphthalate) (PEN), or paper materials such as card stock paper, bond paper, etc. In one exemplary embodiment of the subject matter, the carrier may further include a coating on a side opposite from the adhesive side. It is also contemplated that the carrier may include a coating on one or both sides. The coating can provide desired properties such as anti-fouling, anti-scratching, or other properties. The coating can also serve to block or impede transmission of UV electromagnetic radiation and reduce or prevent ingress of moisture of other agents. International patent application PCT/US2010/060372, the content of which is incorporated herein as reference, describes a fluorinated coating, designated herein as FP, for such purpose.

The adhesive layer 230 bonds the conductive metal layer 220 with the carrier substrate 210. The adhesive layer can be a structural adhesive such as epoxy based curable adhesives, or pressure sensitive adhesives such as acrylic or rubber based pressure sensitive adhesives. It is preferred that the adhesive is a two stage cured adhesive. Typically, such adhesives are characterized by having a first stage cure or "stage A" followed by a second stage cure or "stage B" cure. When the stage A curing is conducted, the adhesive provides sufficient adhesion between the metal foil and the carrier so that laser patterning can be performed on the foil laminate. When stage B curing is conducted after the removal or stripping off of unwanted portion(s) of the metal foil, the adhesive provides permanent bonding between the patterned foil and the carrier.

The conductive metal layer 220 can be made of any metal that provides satisfactory electrical conductivity and stability. Exemplary metal foils include copper foils and aluminum foils. It is also contemplated that combinations of these metals can be used such as in layered arrangements in which a layer of copper covers at least a portion of an aluminum layer. When aluminum foils are used, additional processing is preferred to remove a naturally occurring oxide layer on the surface of the foil prior to forming a reliable conductive attachment. This can be performed at the time of attachment or prior to attachment. The freshly exposed aluminum surface with the oxide layer removed is preferably protected by a more stable conductive material as in the case in which the oxide is removed prior to conductive attachment as in solar module manufacturing. One exemplary conductive material is a thin layer of copper, which can be electroplated over the aluminum surface. Although electroplating is noted, it will be appreciated that deposition of the metal such as copper can be performed by other techniques such as sputtering or electroless plating, or printing a conductive material such as silver. The thickness of such copper layer can be in the micron or submicron range. Various methods of treating the aluminum surface have been disclosed in pending US provisional application 61/451,661, which is incorporated herein by reference in its entirety. The treatment on the aluminum surface can be conducted prior to the lamination with the carrier film, or after the lamination. When copper foil is used, it is sometimes protected by a more stable conductive material, such as silver, or organic solderability preservative (OSP). The silver can be applied onto copper either before the laser patterning, or after. The OSP can be applied onto copper before the patterning. The OSP coating has been demonstrated to provide excellent results for contact points that are usually covered by silver, and has passed the most difficult environmental tests for many thousands of hours. This is a preferred solution for use with copper foil without any silver plating, and hence provides a more economical solution. The conductive metal layer 220 is preferably patterned so that the layer 220 forms a complete electrical circuit when aligned or otherwise incorporated with another component of an electronic module, such as a RFID chip, RFID strap for a RFID tag, or a crystalline silicon (c-Si) cell for a photovoltaic module. It will be appreciated that a wide array of components are contemplated such as switches, transistors, resistors, capacitors, speakers, displays, and other electronic components.

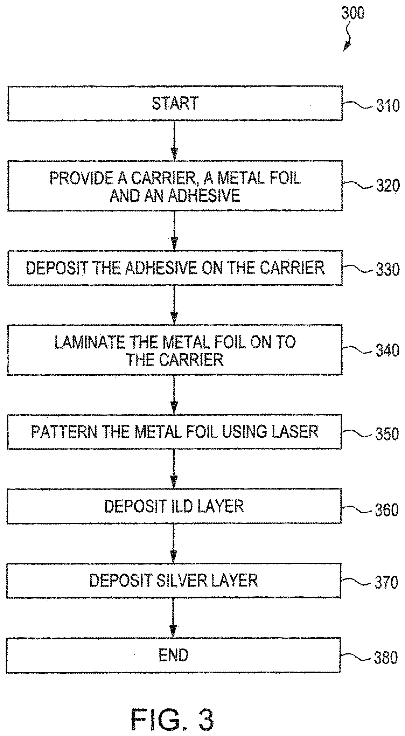

The patterned conductive metal layer such as layer 220 in Figure 2 can be produced using the following preferred embodiment process 300 as schematically shown in Figure 3. Starting at operation or step 310, a substrate layer, an adhesive, and a conductive metal foil 220 (see Figure 2) are provided in step 320. Then the adhesive layer is deposited upon the substrate layer at step 330. The adhesive may be applied to the carrier substrate by slot coating, roll coating, screen printing, digital printing, or other type of pattern printing process. Then the conductive metal foil can be laminated on the substrate layer through the adhesive layer at step 340. The metal foil can then be patterned according to a predetermined first pattern through a laser cutting process at step 350. This predetermined first pattern forms the desired circuitry and ensures that electric shortages do not occur when the patterned conductive foil is completed. This process has been described in detail in pending US provisional patent applications 61/354,380, 61/354,388 and 61/354,393, all of which are incorporated by reference in their entireties. At step 360, an ILD layer is deposited on the metal foil surface according to a predefined second pattern. This second pattern covers most regions of the metal foils, with only regions at which electrodes are to be left uncovered. Then at step 370, a silver layer is deposited on the metal foil that is not covered by any ILD to form the electrodes for connecting with the contact pads of a silicon cell. The process ends at 380. It will be understood that in many applications, steps 360 and 370 are optional. Furthermore, step 370 can also utilize an organic solderability preservative (OSP) or an electrically conductive material.

The thickness of each layer in the preferred embodiment assemblies depicted in Figure 2 is as follows. The thickness of the carrier substrate 210 is from about 1 mil (25.4 micrometers) to about 25 mils (635 micrometers). The thickness of the adhesive layer 230 is from about 1 micrometer to about 40 micrometers. The thickness of the metal foil 220 can be from about 10 micrometers to about 200 micrometers. The thickness of the silver layer 240 can be from about 0.05 micrometer to about 10 micrometers. The thickness of the dielectric materials 224 can be from about 5 micrometers to about 50 micrometers.

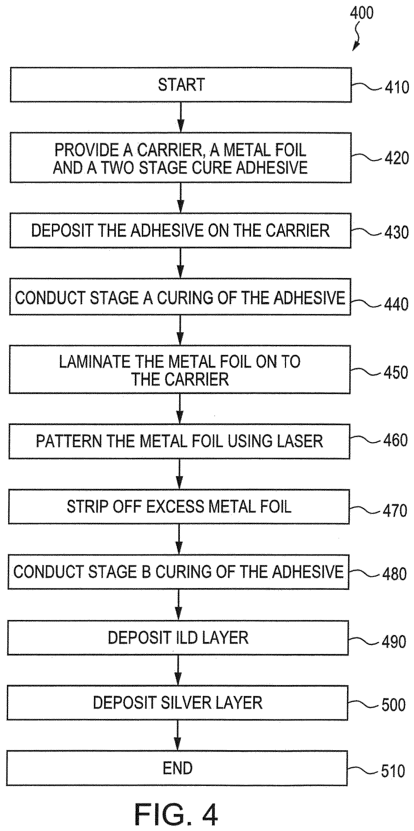

Reference is now directed to Figure 4, which schematically illustrates another preferred embodiment process 400 of producing flexible circuitry for a back contact photovoltaic backsheet. Starting at operation or step 410, a substrate layer such as for example layer 210 in Figure 2, a two stage adhesive such as layer 230 in Figure 2, and a conductive metal foil such as layer 220 in Figure 2, are provided in step 420. Then the two stage adhesive layer is deposited on the substrate layer at step 430. The adhesive may be applied to the carrier substrate by slot coating, roll coating, screen printing, digital printing, or other type of pattern printing process. Next at step 440, the stage A curing is conducted to create a sufficient adhesion between the carrier and the foil for handling in the next step. This can also occur after the laminating step. In many applications this will likely occur prior to the laminating step. Then the conductive metal foil can be laminated on the substrate layer through the adhesive layer at step 450. The metal foil can then be patterned according to a predetermined first pattern through a laser cutting process at step 460. As part of the first pattern, separation such as lines 170 in Figure 1b are made around the foil towards the edge of the laminate to separate excess foil regions from the foil portions used for the circuitry. The pattern ensures proper functioning of the electrical circuit formed when multiple photovoltaic cells are connected to the photovoltaic backsheet with proper connectivity and avoids electrical shorting. Next at step 470, the excess foil around the edges of the laminate is stripped off. Then the stage B curing is conducted to permanently bond the foil with the carrier at step 480. At step 490, an optional ILD layer is deposited on the metal foil surface according to a predefined second pattern. This second pattern preferably covers most of the region of the metal foil, with only places where electrodes are to be made left uncovered. Representative materials for the interlayer dielectric include UV curable dielectric inks. Preferred characteristics for the interlayer dielectric material include high bonding adhesion to the conductive surface, consistent and reliable dielectric properties and high thermal/dimensional stabilities. Preferably, the interlayer dielectric material is in the form of an ink. A typical ILD ink, such as commercially available from Henkel AG, Düsseldorf, Germany; and SunTronic Dielectric 680 (CFSN6052), SunChemical, Norton Hill, Midsomer Norton Bath, BA3 4RT, England can be used. Preferably, the interlayer dielectric material is applied onto the conductor by a screen printing process. The applied interlayer dielectric material is then subjected to a UV curing step for example by exposure to UV light at 650 mJ/m² intensity. The desired target thickness is about 10 to about 30 micrometers and most preferably about 15 micrometers to ensure the layer is pinhole-free or free of other defects.

Then at step 500, an optional silver layer is deposited on regions of the metal foil that are not covered by any ILD to form the electrodes for connecting with the contact pads of a silicon cell. The process 400 ends at step 510. Steps 490 and 500 are only a portion of one of the preferred embodiments. They are optional as previously noted. One or both of steps 490 and/or 500 may or may not be used in other preferred embodiments.

### LASER PATTERNING PROCESS

In order for laser patterning to be suitable for industrial applications forming electrical circuitry, the process has to meet a number of requirements. To lower the cost in comparison with conventional chemical etching processes, such requirements also include the following. The speed of the process should be relatively fast in order to be competitive with conventional etching processes. For example, the linear speed is preferably greater than 1 m/s, and preferably 1.5 m/s to more than 2 m/s. The present subject matter includes faster speeds such as greater than 2 m/s. In certain applications, patterning is performed at a speed of at least 400 mm/s. In other applications, patterning is performed at a speed of at least 1,000 mm/s. And, in still other applications, patterning is performed at a speed of at least 2,000 mm/s. The pattern generated should provide good electrical insulation between the separated areas. For example in Figure 1B, the area 170 free of metal foil preferably has a minimum width or gap, referred to herein as "kerf". When the gap is not wide enough, electrical shortages can occur. In addition, droplets or particles of ablated metal may deposit and accumulate to bridge the gap formed by laser ablation and also lead to electrical shortage. The current industrial practice using chemical etching creates a gap on the order of one or more millimeters. Creating a wider gap using laser ablation requires higher power of the laser, very large spot size of the laser, multiple passes of laser ablation and leads to slower rates of manufacturing. The minimum kerf is about 50 micrometers. In certain applications, the minimum kerf width is about 200 micrometers or more. The carrier should remain without any damage throughout the entire patterning process as the carrier has a primary role in protecting the sheet assembly from moisture, UV and other environmental attacks.

Additional layers present on the foil laminate in the patterning process can be, for example, a coating on the back side of the carrier, opposite to the adhesive side, for additional strength or protection. Such additional layers can also be disposed on both sides of the carrier.

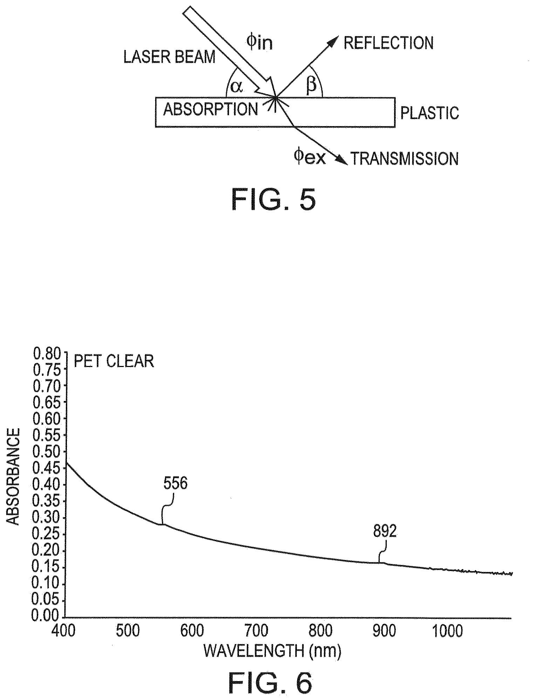

In performing the preferred embodiment process, the laser(s) which are used exhibit certain characteristics. An ideal laser is one in which the metal material exhibits a relatively high degree of absorption of energy upon exposure to the laser emission; and in which the adhesive, carrier and/or other layers exhibit a relatively low degree of energy absorption. The low absorption can be achieved through high reflection or high transparency to the laser beam, as schematically illustrated in Figure 5.

Although the laser beam energy decreases while ablating the conductive material, the remaining energy arriving at and passing through the polymer substrate may be enough to damage the substrate if the absorbed energy is greater than a certain amount. This depends on the polymer used and its thickness. The measurements presented in Figure 6 illustrate the absorbance for a relatively transparent polyethylene terephthalate (PET) film of 250 micron thickness at a spectrum of wavelengths. Absorbance (Abs) at a given wavelength is approximated as : Abs = Log (I_{incident}/I_{transmitted}). At approximately 1000 nm, the absorbance measured in transmission mode is about 0.14 (72% transmitted), while in the range of from about 500 nm to about 600 nm, the absorption is about 0.30 (only 50% transmitted). The PET absorption is relatively low in the visible spectrum and will be even lower when wavelengths around 1000 nm are used.

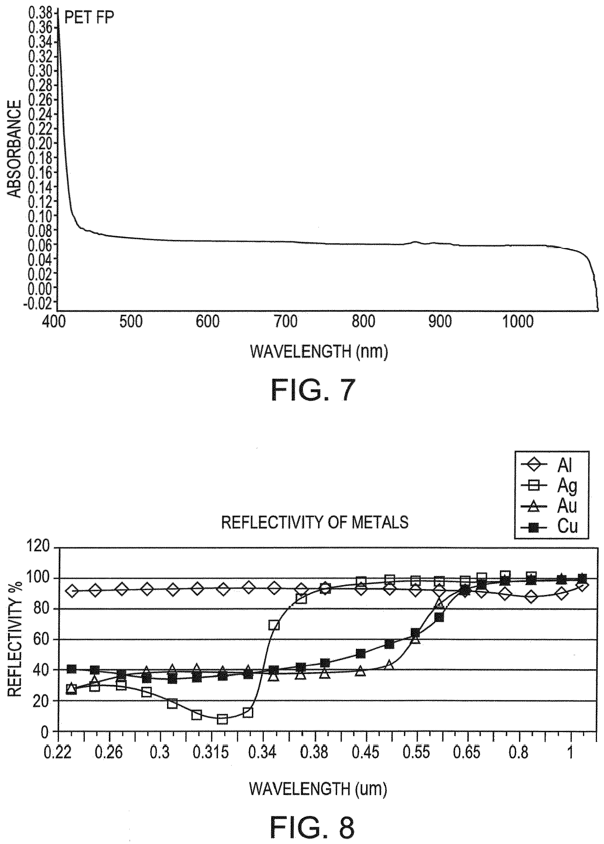

Figure 7 shows the absorbance of a PET film coated with a fluorinated coating, i.e. "FP" for the same spectra but measured in diffusion mode. Figure 7 shows no change in the absorbance for all visible wavelengths to near or short IR (up to 1100 nm). These measurements demonstrate that the laser wavelength to consider for not damaging the laminate material when ablating the top metallic foil should be in the visible to short IR wavelengths. Even though it is known that UV lasers result in higher absorption for copper or aluminum than other types of lasers, UV lasers are not suitable as they also damage components in a multilayer assembly such as PET when used as a carrier.

To identify preferred lasers for ablation of copper and aluminum, different types of solid state lasers were considered. Such lasers are classified by wavelength, pulse (or continuous), pulse duration, power and frequency. Also different types of active media were considered: Rod lasers, microcrystal lasers, slab lasers, fiber lasers, thin disk lasers and most recently short fiber-rod type lasers.

Figure 8 shows the reflectance of aluminum, copper, gold and silver. At wavelengths of greater than about 700 nm, which are the fundamental wavelengths of most commercially available fiber lasers, copper and aluminum exhibit a relatively high reflectivity of greater than about 95%. At green range wavelengths obtained by frequency doubling of those lasers, the reflectivity of aluminum remains the same, while the reflectivity of copper decreases to around 50%. Absorption measurements given by Jeff Hecht in "Understanding Lasers", chapter 10 are shown in Table 1.

**Table 1 - Absorption of Aluminum and Copper at Various Wavelengths**

| Material | Argon (Green, 500 nm) | Ruby (694 nm) | NdYAG (IR, 1064 nm) | CO₂ (10.6 micrometers) |
|---|---|---|---|---|
| Aluminum | 9% | 11% | 8% | 1.9% |
| Copper | 56% | 17% | 10% | 1.5% |

Copper has 5 times better absorption at green wavelengths than at IR wavelengths of around 1 micron. There is on the other hand higher absorption of green radiation by PET as compared with IR as seen in Figure 6. The evaluations showed that in most laser conditions the green laser damages the PET substrate.

One of the parameters having a significant effect upon the results of ablation of copper is its high thermal conductivity. The thermal conductivity of copper (401 J/s.m.K) is much higher than the thermal conductivity for aluminum (237 J/s.m.K). Thus, the relatively high thermal conductivity of copper results in higher heat flow through the cross section of copper foil which results in faster cooling of the heated location and thus a need for higher energy densities. Also observed is a higher effect of laser repetition rate due to this rapid cooling between two laser pulses. However, the specific heat capacity (the amount of heat to raise the temperature of 1 g of material, 1 C or 1 K) is 0.385 J/g K for copper and 0.897 J/g K for aluminum. However, the specific weight of copper is 8.94 g/cm³ and the specific weight for aluminum is 2.70 g/cm³. The result of these properties is that the same volume of copper requires 1.42 times more heat than aluminum to raise its temperature by 1 K. This is the same ratio of aluminum foil volume to copper foil volume (35 micrometers/25 micrometers) derived from electrical conductivity of these metals. Thus the thermal conductivity is a primary reason for higher energy density which is needed to ablate copper in comparison to aluminum. Consequently, the primary parameters that are expected to affect laser processing of copper and aluminum are their absorption coefficients and their thermal conductivities.

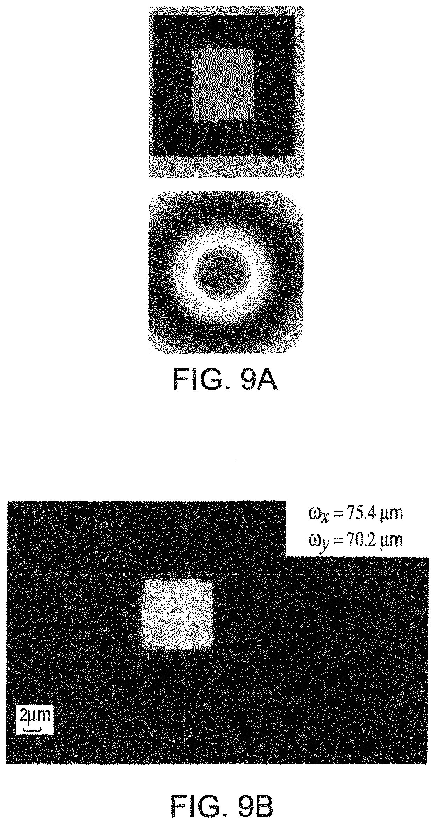

The preferred laser beam configurations can be described as "top hat" and gaussian (see Figures 9A and 9B, respectively) according to the profile of beam intensity. Gaussian type beams like a gaussian function have higher intensity at the center of the beam, and lower intensity towards sides or periphery of the beam. Top hat beams have relatively uniform beam intensity across the span of the beam. Figure 9B illustrates a square top hat profile with intensity in both directions. Top hat beams may be in a square shape or round shape depending on the type of fiber used. Several commercially available laser systems which may be used in the preferred embodiment processes are as follows. High power, short pulse lasers such as TruMicro Series 7000 disk lasers by Trumpf (Ditzingen, Germany) combine the requirements of microprocessing with high average power in an ideal manner. These disk lasers, for instance the 7050 series, offer short pulses of 30 ns at 1030 nm wavelength independant of their repetition rates. These lasers have a high pulse energy of up to 80 mJ with repetition rates of up to 100 kHz. Frequency conversion is also possible even for pulse lengths into the high nanosecond range. Using a frequency doubled version of these disk lasers (Trumpf 7240 series) with a wavelength of 515 nm and high pulse energies, entirely new applications such as drilling and cutting in silicon or copper, and in annealing are also possible. Other commercially available laser systems which may be used in the preferred embodiment methods include high power IR fiber lasers from IPG Photonics (Oxford, MA, USA); InnoSlab lasers from EdgeWave (Wurselen, Germany) and rod-fiber lasers from EOLite systems (France). The new 500 W YLP fiber lasers from IPG are another preferred laser system for this application.

A wide range of evaluations in view of providing a production system for patterning roll to roll sheets of copper and/or aluminum laminates were undertaken. The main laser used was the 7050 Disk IR laser from Trumpf with a 460 µm square fiber and with a 400 µm round fiber. Top hat laser energy distribution is generally preferred for conducting the ablation in order to achieve wider kerfs with cleaner grooves or edges. The large laser spots from the 460um square or the 400 µm round delivery cables permit ablation of wide kerfs if enough enery density is present, without a need for multiple passes of laser which dramatically reduce the overall speed.

In other embodiments of the subject matter, photovoltaic modules are provided. These photovoltaic modules preferably include a c-Si cell in electrical connection with a backsheet. The backsheet includes a substrate and a patterned conductive metal layer as described herein.

Throughout this disclosure, the term "layer" refers to either a continuous material layer, a discontinuous material layer, or a discrete material layer.

Other features and advantages of the present subject matter will become apparent to those skilled in the art from the following detailed description. It is to be understood, however, that the detailed description of the various embodiments and specific examples, while indicating preferred and other embodiments of the present subject matter, are given by way of illustration and not limitation. Many changes and modifications within the scope of the present subject matter may be made without departing from the spirit thereof, and the subject matter includes all such modifications. Exemplary modifications include using metal foils other than copper or aluminum; using other conductive metals for forming the electrodes other than silver; using patterns other than illustrated in the drawings, and replacing laser ablation and/or cutting with a traditional die cutting operation, such as for example before stripping off of excess metal foils.

In certain applications it may be preferred to protect the carrier which is generally polymeric, from the laser, i.e. light emitted from the laser. Protecting the underlying carrier can be performed using a variety of strategies. In one technique, one or more additives are incorporated in materials that are applied or deposited on a carrier face and which serve to prevent or reduce the extent of transmission of laser light to or into the polymeric carrier. For example, the one or more additives can exhibit light reflecting or light blocking properties. The one or more additives can be inorganic particulates such as metallic powders. The one or more additives can be organic materials. In another technique, the polymeric carrier can be protected by depositing a thin light-reflecting or light-blocking layer on the carrier. For example, a thin metal layer can be deposited on the carrier face to prevent exposure of the carrier to laser light. These techniques can be utilized in conjunction with each other or used in association with one or more other techniques. As described in greater detail herein, in certain applications the laser emits light having a wavelength in the green range, i.e. about 500 nm to about 570 nm. The green light is more compatible with copper material. And so, using the carrier protection strategies noted herein, at least a portion of the emitted laser light is reflected away from the polymeric carrier by one or more of (i) additives in an adhesive layer, and/or (ii) a metal layer on the carrier. Any of the protection strategies can be performed before, during, and/or after lamination of a metal foil or layer. It is contemplated that typically, protecting an underlying carrier will be performed prior to patterning.

### Examples

In order to further evaluate the preferred embodiment processes and related assemblies, various samples were prepared as follows. Copper foil of 25 to 35 micrometers thickness or aluminum foil of 35 to 50 micrometers thickness was laminated onto 125 or 250 micrometer S10 PET from Toray, USA using a two stage adhesive. A fluorinated coating, designated herein as FP by Avery Dennison, was coated on the back of the PET films at about 5 to 30 micrometers thickness. The adhesive was cured to stage A by UV radiation and a conductive foil was then laminated on this PET subassembly using the coated adhesive. Areas to be stripped or delimited by cutting through the metallic foil were subjected to mechanical kiss cutting or by exposure to a laser, without damaging the PET. The adhesive in stage A has sufficient adhesion to the foil to keep it in place but not enough to prevent intended delamination. The foil areas defined in this manner were then stripped away from remaining foil regions and the adhesive was cured by thermal means to stage B at which the adhesive became permanent.

### Example 1

In this evaluation, a pulsed fiber laser from LasX operating at a wavelength of 1064 nm, power of up to 100 W and pulse energy of up to 1 mJ was used. The laser was operated to ablate a 50 micron thick aluminum foil. The aluminum was completely ablated with speeds up to 1100 mm/s. However, the procedure was not successful in achieving sufficient kerf width.

### Example 2

A pulsed YLP fiber laser from IPG with the following parameters was used to ablate aluminum foil: wavelength 1064 nm, power 200 W and pulse energy 10 mJ. The procedure achieved on aluminum foils a kerf width of 150 to 160 micrometers up to a speed of 1500 mm/s. IPG fiber lasers, YLP series, at 200 W were also used to ablate copper foil. It was concluded that this 200 W laser using a wavelength of approximately 1064 nm is not optimum for copper. A pulse duration of 400 ns is too long to permit high enough peak power, and a beam quality of M**2=8 to 10 was not enough to achieve any suitable results for ablation of the copper foils.

### Example 3

Also evaluated was the processing of aluminum laminated foils using Innoslab lasers from Edgewave (Wurselen, Germany) with gaussian beams. Aluminum foil was ablated to form 30-40 µm wide channels at 250 mm/s. But available lasers were not powerful enough to get wide kerf ablated lines and sufficiently high speeds. Also evaluated were lasers with square top hat beams. A two dimensional top hat laser of 50 W with a homogeneous energy distribution can significantly increase the production efficiency for ablation of aluminum foil while also providing a wide ablated area (about 100µm). Much better results as compared to ablation using a gaussian beam were obtained. In addition, the ablation velocity can be improved to about 750 mm/s by using nitrogen (N₂) as a working gas at 4 bar pressure. Because of the much higher melting point and lower heat capacity of copper it is much more difficult to ablate a copper coating from a PET substrate. It was generally not possible to ablate copper using these low power lasers even at low speeds.

### Example 4

Copper foil was ablated with a 7050 series disk laser from Trumpf. This laser, operated at 1030 nm wavelength with other parameters defined as 750 W maximum power, 5 to 100 kHz repetition rate, pulse energy of 10 mJ, pulse duration of 30 ns and energy density of around 22 J/cm², produced very good results on copper with wide kerf at speeds of 1100 to 1200 mm/s. Acceptable but narrower kerf widths were also obtained at a relatively high speed of 2000 mm/s. In order to pattern a full module of 6 by 10 single photovoltaic panels which includes about 108 m of etched patterns according to one design, the required time to ablate this length of patterns is a maximum of 60 seconds in order for this process to be economically feasible. The ablation speed then needs to be around 1800 mm/s, which is feasible by use of the above noted disk lasers with specific operating parameters developed during trials as demonstrated herein.

### Example 5

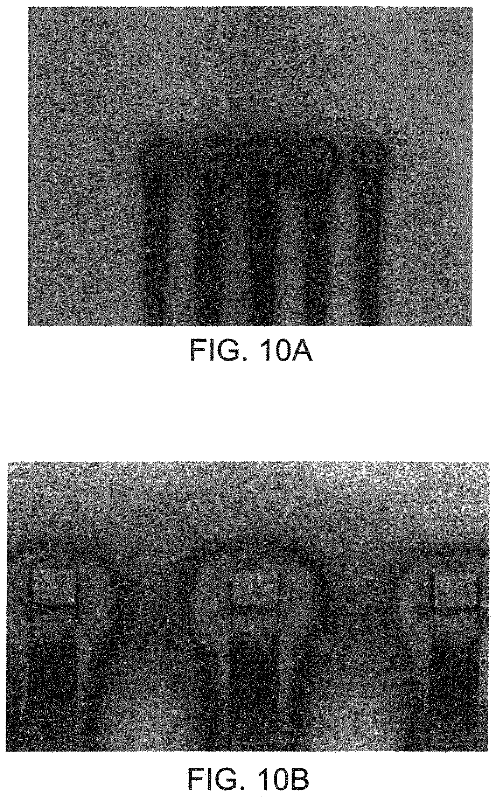

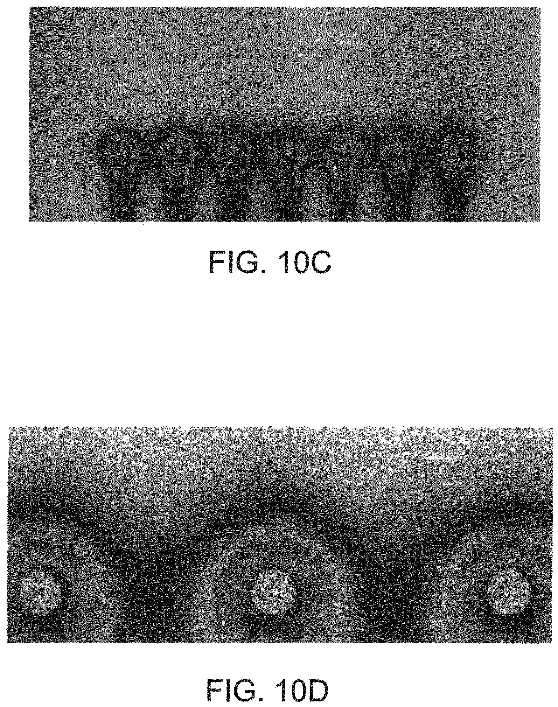

A Trumpf True Micro 7050 laser offers a round and/or square top hat focused beam configuration in which a consistent energy is distributed evenly over the entire focus area. Figures 10A to 10D show the results of fine focusing of square and round fiber delivery cables. In these images the focal plane of the laser is near the center of the image.

There is a significant difference in energy distribution when comparing typical gaussian systems. A first evaluation was equipped with optics with a focal length of 80 mm allowing a 46 mm by 46 mm work area. Ablation was conducted on a 25 micrometer thick Cu laminate on 5 mil PET. The test parameters at 1030 nm wavelength were set at up to 750 W power laser and various speeds of 2.2 m/sec, 2.1 m/sec, 2 m/sec, 1.8 m/sec, 1.6 m/sec, 1.5 m/sec and various frequencies at 23 kHz, 48 kHz, 50 kHz, 53 kHz, and 73 kHz. The pulse width was 30 ns. Two different fibers were tested, a round 400 micrometer fiber and a square 460 micrometer fiber. The square fiber provided better results. Although not wishing to be bound to any particular theory, it is believed that the pulse overlap when using round beam spots could not cover the entire area. This resulted in visible ablation edges. Additional evaluations were performed using 35 micrometer copper foil laminated to a 10 mil PET film with an FP back coating.

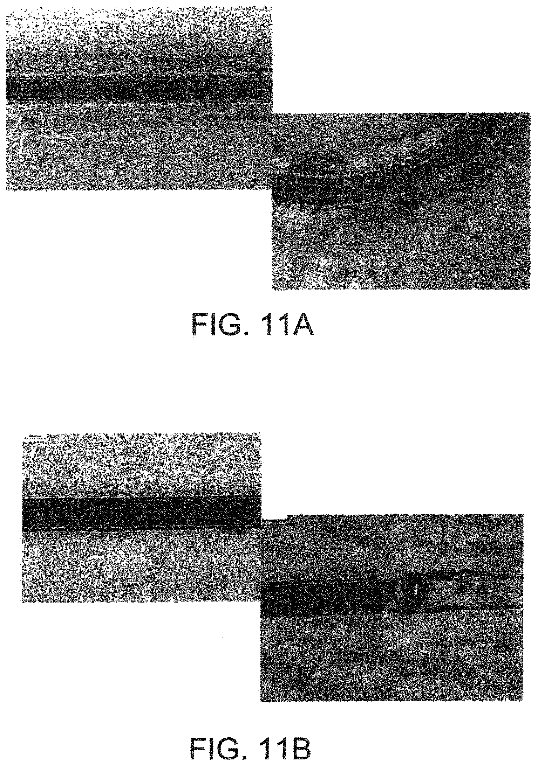

The observations concerning the results of the previously noted ablation tests are as follows. Beneficial results were accomplished at approximately 2 m/sec process speed at 43 to 48 kHz frequency. This translates into fluency of respectively 24 and 22 J/cm². The square fiber (and therefore square focused beam) performed better than a circular fiber/beam. With a circular focused beam, a "ridge" effect was observed on the edges of the kerfs where subsequent beams overlapped. The square shape beam delivered a relatively straight edge. The system did not compensate for the changes in forward speed vector when processing curvatures. That resulted in changes in energy density delivered to the surface which caused burns and melting of the PET film. The evaluation also showed that speed degradation occurs (longer processing time) when kerfs require radial curvatures. When cutting concentric circles with radii of 2.5 mm, 5 mm, 10 mm and 14 mm, an actual linear speed varied from 2 m/sec for a 14 mm radius to 980 mm/sec for a 2.5 mm radius. There appears to be a range for speed/energy density combinations that resulted in fairly smooth edges of the kerfs as shown in Figure 11A (described in greater detail herein). Thus, the preferred methods described herein can be readily implemented in controlled manufacturing processes.

### Example 6

A Trumpf 7240 green laser with 300 W power and 515 nm wavelength was also used to conduct a series of ablation tests. This unit is a top hat type laser as well with a pulse width of 300 ns. The higher pulse width will deliver much lower peak power as compared to the evaluations using the previously noted IR laser. The green laser was equipped with a 100 micrometer square fiber and configured for a focal length of 254 mm thereby providing a scanning work area of approximately 150 mm by approximately 150 mm. Evaluations with different process speeds and varied equipment frequency were conducted.

The observations concerning the results of ablation using this laser are as follows. A 197 micrometer wide kerf was produced at 800 mm/sec speed with an energy fluency of approximately 6 J/cm². The quality of the kerf edge was better than that using an IR laser, but the process speed was significantly lower. Damage to the PET was also more significant. It was suspected that the reason was due to the PET absorption of the green frequency being higher than that of IR. Small changes in the process frequency (amount of energy) delivered to the material resulted in significant changes in the process. The maximum amount of power delivered from the laser did not allow for a complete evaporation of Cu material when attempting to maintain 1 m/sec process speed. Small droplets of Cu were observed to form on the kerf edges and create a possibility of electrical bridges or shorts, as shown in Figure 11B (described in greater detail herein). The 35 micrometer copper samples displayed consistently good results with this green laser at 100 kHz (6 J/cm²) and for speeds of 600 mm/s to 650 mm/s. In order to reduce the penetration of the green light into the PET, inorganic additives such as aluminum powder can be added to the adhesive for reflecting the light at 550 micrometer. Aluminum may also be deposited by metallization on top of the PET before coating adhesive. Organic additives with good reflectivity at green wavelengths may also be used in the two stage adhesive.

Depending on irradiance and pulse duration, different mechanisms contribute to laser ablation of metals. When a metal is irradiated at intensities of 1 GW/cm² to 100 GW/cm² by nanosecond laser pulses as is the case for the methods described herein, the energy is thermally transferred through interaction of photons with electrons (see A. Gragossian, S.H. Tavassoli and B. Shokri in Journal of Applied Physics 105, 103304-2009). In the evaporation mechanism, the sample surface is gradually evaporated and atomic size mass is ejected. With short enough pulse duration the sample can be heated above its boiling temperature. If the temperature increases above the boiling temperature the super heated layer suddenly turns into a mixture of liquid droplets and vapor and the material is removed mainly due to a phase explosion. The IR disk laser intensity was approximately 0.5 to 1 GW/cm² for an energy density or fluency of about 20 to 28 J/cm².

Figure 11A presents the ablation of copper at high speeds of 2 m/s and 2.2 m/s by an IR laser. Specifically, the first and leftmost micrograph illustrates ablation with the noted laser using a 460 µm square fiber cable and at a frequency of 43 kHz. The second and rightmost micrograph illustrates ablation with the noted laser also using a 460 µm square fiber cable and at a frequency of 43 kHz. The micrograph of the straight line illustrates a much cleaner ablation than for the curved line. This is mainly due to lower speeds along curved lines without reducing (in these evaluations) the laser power to achieve the same intensity as in the straight line. In both micrographs melted droplets are apparent that are ejected from the ablated area. An extended field of a hundred microns or more is observed around the ablated groove which according to literature (L. Tunna et al. in Optics & Laser Technology 33 -135-143) is consistent with melt/vaporization dominant regime where fine droplets and condensation of the metal vapor lead to formation of fine particles surrounding the groove. The extensive recast layer also shows the existence of extensive heating of the copper surface which is a sign of poor coupling of the high power 1030 nm laser light with copper.

Figure 11B illustrates two cases of results of ablation using the green (532 nm) laser. Specifically, both micrographs illustrate ablation with the noted laser at a frequency of 100 kHz, on 25 µm copper. It was previously noted how green laser at 515 nm has a better coupling with copper as compared to an IR laser at 1030 nm. The first micrograph illustrates a much cleaner edge with less recast of the condensate material around the groove. However, this does not provide a consistent process due mainly to the fact that this laser is operating at much lower intensity as compared to that of the IR laser. The fluency is around 4 to 8 J/cm² and the maximum power intensity is approximately 40 MW/cm². As soon as the speed is slightly increased large droplets were observed to be forming and either deposited around the groove or as seen in the lower micrograph rightmost in Figure 11B, deposited in the groove. The amount of deposited material is such that it could not be ablated by a second pass even at lower linear speeds. This indicates processing at the lower end of a melt ejecting intensity range where most of the melt generated remains largely within and near the groove. The need for large kerf width of more than 100 micrometers translated to a need for large spot sizes of more than 200 by 200 micrometers in both IR and green lasers. The evaluations led only to acceptable limits of energy and power densities despite high laser powers available. Until additional investigation is performed for protecting the PET from green radiation, it was decided to use an IR laser for manufacturing not only because of its higher energy densities but also due to the fact that PET is essentially transparent to this wavelength. No damage was visible to the PET layer or to its FP coating. The green laser with its higher absorption by PET was seen to damage this vital layer. Although the damage was not significant, the extent of damage might be enough to lower the quality of the product as a result of effects upon the long term protection of the conductive backsheet. The metallization of an aluminum layer to protect the PET layer or the addition of additives to the adhesive are believed to be technically possible but not economically viable in certain applications. However, in other applications, such techniques for protecting a polymeric carrier may be acceptable.

Evaluating the previously noted high power IR and green lasers for ablation of 50 micrometer and 35 micrometer aluminum laminated foil or aluminum laminated foil plated with 2-3 micron copper and protected by OSP coating presented significantly fewer difficulties. The Trumpf IR laser can be split into two beams and be used to ablate aluminum or Cu plated Al foil at speeds of more than 2 m/s. As previously noted, good results were also achieved for ablation of aluminum foil using a 200 W fiber laser from IPG as well. The aluminum foil with or without thin copper plating is a much better candidate for laser patterning as compared to copper foil.

### Example 7

In order to investigate the ablation process in more detail, a laser was selected based upon the best results from the feasibility investigations reported in the previously noted examples. The laser selected was a Trumpf 7050. A workstation was assembled in order to achieve linear speeds of up to 1500 mm/s on straight lines and an average speed of up to 750 um/s when considering the patterning of a panel as presented in Figure 1B or 2 by 2 panels in Figure 1C.

### SCANNING BEAM OR FIXED BEAM APPARATUS

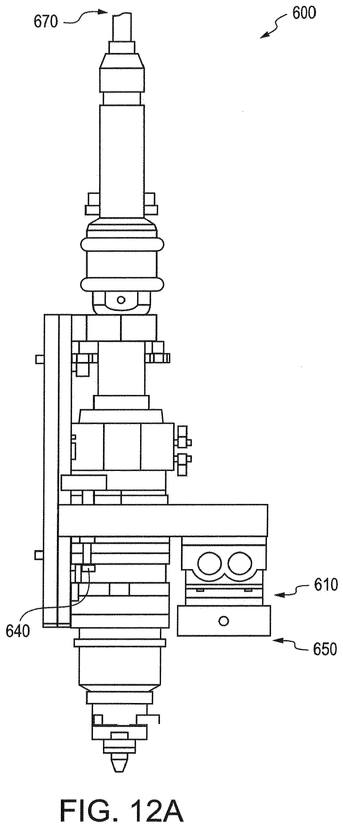

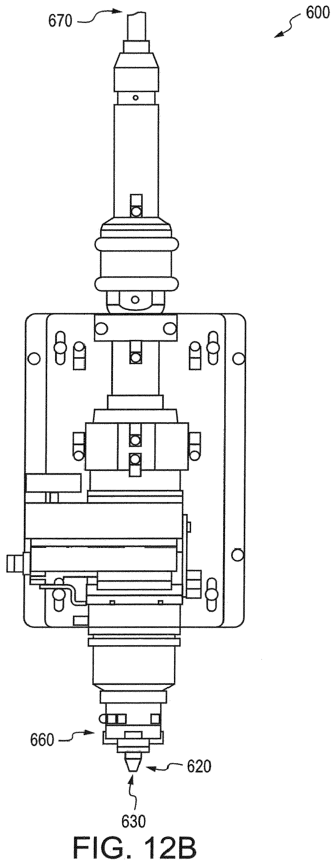

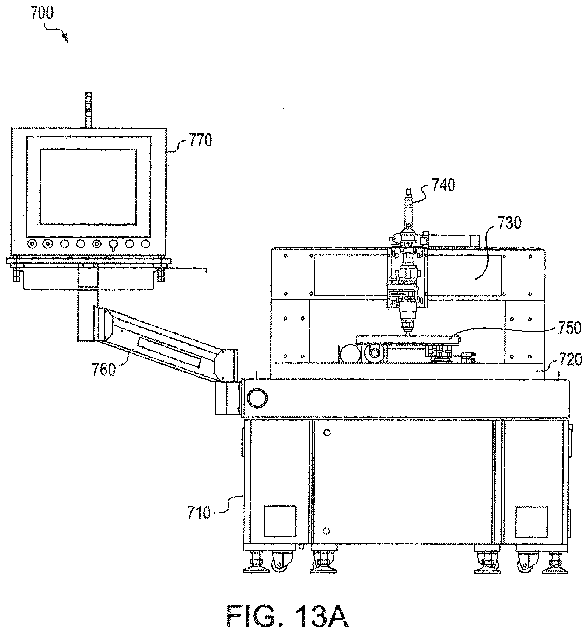

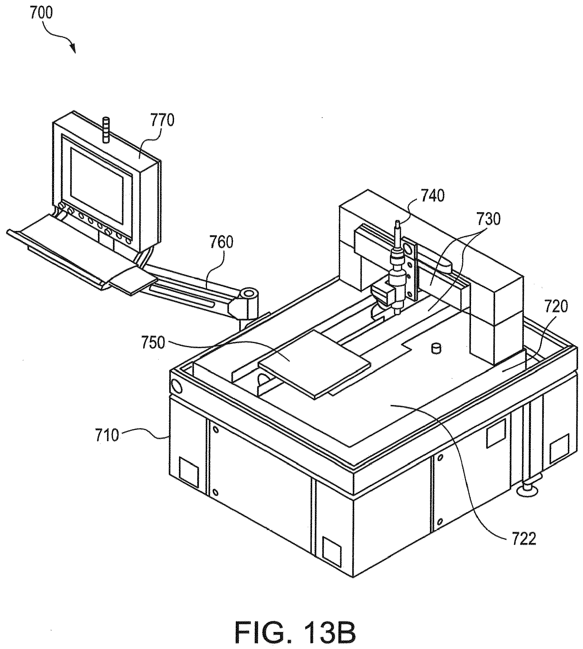

It was determined that the largest achievable field size using scanners for relatively large fibers is on the order of 50-60 mm on each side. With this field size, to pattern a panel of the type shown in Figure 1C, there will be approximately 680 indexing movements required by a gantry system to position the scanner field over the entire panel. The time required for these indexing movements alone makes this solution impractical. This is the reason a fixed beam focusing assembly moved by mechanical actuators was utilized. A cutting head allows for the use of much shorter focusing optics and consequently smaller spot sizes. Figures 12A and 12B illustrate a preferred embodiment focusing assembly 600 used for these trials. This assembly comprises a main body to direct and focus the laser light coming through a fiber 670. A set of focusing optics permits changing the focus distance of the laser. The focusing optics include the 2:1 imaging of the square or round fiber light input (670) onto the work piece. A camera 610 provides automatic registration of parts through a vision light 650 prior to the laser processing. A height adjustment screw 640 is provided for course adjustments. Fine adjustments are made using a program interface presented on the monitor 770 in Figure 13. An assist gas input 660 (Figure 12B) permits connection of various types of gas to be directed towards the work piece through a nozzle output 620 (Figure 12B). These gases with different pressures are provided to assist in removing the molten metal from the groove. The following assist gases were used for the trials described herein: air, argon, oxygen and nitrogen. A laser light 630 is directed to the work piece through the same nozzle used for assist gas delivery. Two options are considered for the cutting head solution, the use of a 400 µm round or 460 µm square fiber cable. The cables 670 are connected to the focusing head (see Figure 12A) before any optical adjustment. For these options, it is assumed that the laser spot overlap is at approximately 90% and that the energy density at the foil surface is at least 20 J/cm². Both of these requirements are based on results achieved during the feasibility evaluations previously described. In the case of either of these two fibers, it was decided to utilize 2:1 imaging of the fiber face to achieve a spot size of 200 µm diameter round or 230 by 230 µm square. This was preferred as compared to a 1:1 imaging for higher fluencies. Thus, increased flexibility was achieved during evaluating a larger range of power adjustments.

Gantry Motion: A workstation was designed and built, as shown in Figures 13A and 13B. Specifically, a Trumpf 7050 IR Laser with a fixed beam was integrated into a test workstation built by LasX Industries (St. Paul, MN). The system was designed to move the gantry at linear speeds of more than 1.5 m/s. However, it was a challenge to move the gantry at speeds as low as 750 mm/s in the curvatures of the patterns (see Figure 1B for example) due to the heavy focusing beam assembly in cross direction movement and the heavy vacuum stage (holding the substrate in place) in web direction movement. As a result, lower speeds for gantry movement were used in order to form the contours of the panel design. Specifically, Figure 13A and Figure 13B illustrate a preferred embodiment workstation 700 with a fixed focusing assembly as described herein. The workstation 700 comprises a frame or support assembly 710 which supports or provides mounting or affixment for a base and bridge assembly 720. The base and bridge assembly 720 serves to absorb or otherwise deaden vibration. The base and bridge assembly 720 is typically horizontally oriented and defines an upwardly directed flat face 722. The base and bridge 720 can be formed from various materials including but not limited to granite. The workstation 700 also comprises linear motor stages 730. As will be appreciated, the motor stages typically include two transversely oriented stages oriented in X and Y directions, respectively. The workstation 700 also comprises a fixed beam laser optics assembly collectively shown as 740. And, the workstation 700 also comprises a vacuum table 750 for holding or retaining one or more components or assemblies. A typical table is 400 mm by 400 mm which can be selectively positioned in a vertical or Y-axis direction. The workstation 700 can also comprise a monitor or other operator interface 770 which can be selectively positionable by use of a mounting arm 760.

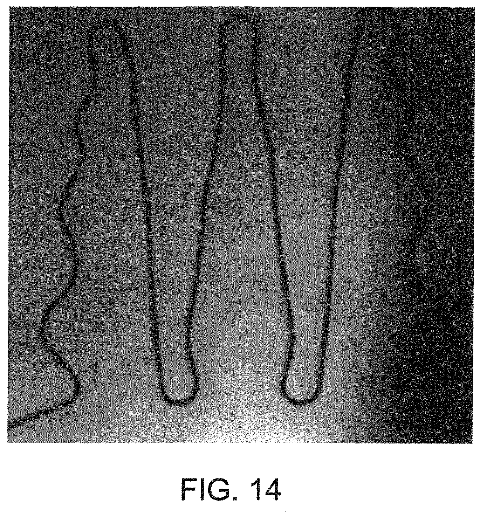

Beam Shuttering or Attenuation: When two ablation vectors cross, the second pass will not have to remove any copper/aluminum and thus will be directed at high energy through the substrate causing damage to PET. For this to be prevented, the beam needs to be either shuttered or attenuated. Trumpf offers a safety shutter, which could potentially be used. However the response time is relatively slow (50-100 ms) and would likely cause undesirable start/stop effects in the laser cut. The other potential solution is to use computer controlled optics in the cutting head that would change the focused spot size. This is a strategy used for ablation of copper in the contours of the patterns in Figures 1B and 1C although at much smaller change as compared to the vector crossings in which the strategy is needed to almost completely attenuate the beam. In this way, when the beam passes in a contour and the stage slows down, the focused spot size could be increased and the resulting energy density would be reduced. Figure 14 illustrates a panel patterned by ablation on copper laminated onto 250 µm (10 mil) PET with Avery Dennison FP coating. The laser process parameters were 35% of maximum power, repetition rate of 22.5 kHz and moving at 450 mm/s speed. The assist gas was either compressed air at 1 bar or argon at 0.5 bar both from a 1 mm diameter nozzle. The resulting panels passed 3kV electrical tests (described in greater detail herein) used to check the isolation of conductive paths.

Approximately 600 test conditions were evaluated to determine a preferred process window for laser ablation. This was performed by first determining the maximum processing speeds with the workstation. A significant challenge was to identify a solution for eliminating or significantly reducing recast material on kerf edges. For a module to function without any potential electrical shorts between the conductive backsheet and the solar cell especially when no ILD is used, the height of recast or re-deposited materials was determined to not be higher than about 35 µm (same as copper thickness).

The factors used for evaluations were: two types of foil thickness (25 micrometer and 35 micrometer), various ablation speeds (from 300 to 1500 mm/s), varying percentages of maximum power (from 20% to 100%), several frequencies (from 10 kHz to 50kHz) hence various pulse energy, distance per pulse and pulse overlap as well. In addition, two nozzles (1 mm and 0.5 mm diameters) were used for assist gas to evaluate the influence of various assist gases and their delivery pressure on the substrate. The assist gasses used were compressed air, argon, oxygen and no assist gas.

### EVALUATIONS USING SQUARE FIBERS

As was previously described in Example 6, the ablation regime appears to be consistent with the melt/vaporization dominant regime where the mass of ablated material ejected from the groove (line) rapidly condenses and is re-deposited on the edge and around the ablated line. Although various regimes were observed by changing the laser parameters, the melt/evaporation appears to be the dominant regime when quality ablated patterns are obtained. It is believed that further evaluations will identify the best laser process parameters and the type and amount of assist gas to achieve optimal ablation quality on copper foil. An interesting discovery was that excellent results were achieved at very high linear speeds but it was only possible to ablate straight lines at these speeds with the workstation used in these evaluations.

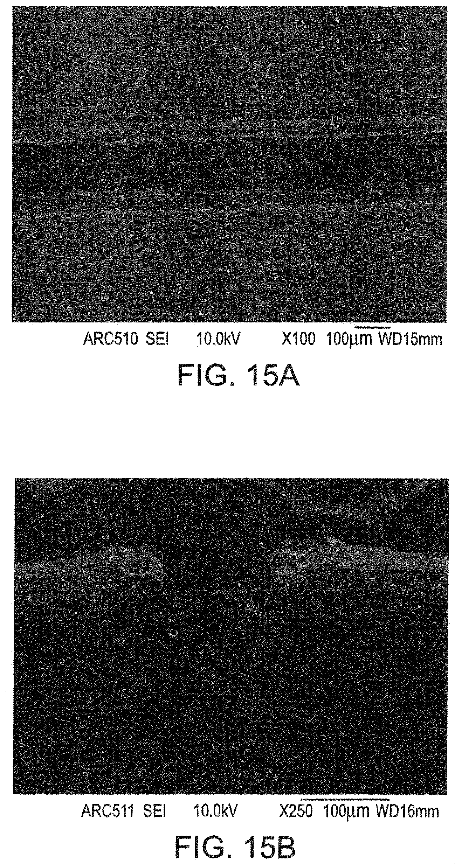

The Scanning Electron Microscope (SEM) images presented herein are the results of evaluations conducted using a square fiber with 230 by 230 micron spot size. The images presented in Figures 15A to 16B illustrate the quality of various ablated lines obtained on the panels patterned by the laser system described herein. The SEM photographs of Figures 15A and 15B are taken from a top view and cross sectional view respectively, of samples cut from high speed evaluations on the 25 µm Cu material at 1.5 m/s processed under a repetition rate of 45 kHz and 50% of maximum power. Figure 15B indicates no PET damage and no copper delamination. The ablated lines are processed in the presence of 1 bar of assist air from a 1 mm diameter nozzle around the laser beam. See the process parameters presented in Table 2, below. The assist gas is blown to the work area by a nozzle through which the laser beam is also delivered. Two types of nozzles were evaluated: 1 mm and 0.5 mm. The measured width of recast on one side is 60 µm and on the other side 60 µm. The width/kerf of the ablated line is 138 µm. The height of recast along an edge was measured as being only 8 µm.

**Table 2 - Process Parameters Used for High Speed Tests With a Square Fiber**

| Parameter | 35 µm Foil | 25 µm Foil | Units |
|---|---|---|---|
| Process Speed | 1200 | 1500 | [W] |
| Laser Power | 50 | 50 | [%] |
| Laser Power | 375 | 375 | [W] |
| Frequency | 45 | 45 | [kHz] |
| Pulse Energy | 8.33 | 8.33 | [mJ] |
| Laser Spot Area | 5.29e-4 | 5.29e-4 | [cm²] |
| Fluence | 15.75 | 15.75 | [J/cm²] |
| Spot Overlap | 88.4 | 85.5 | [%] |
| Assist Nozzle Dia. | 1 | 1 | [mm] |
| Assist Gas | Air | Air | |
| Assist Gas Pressure | 1 | 1 | [bar] |

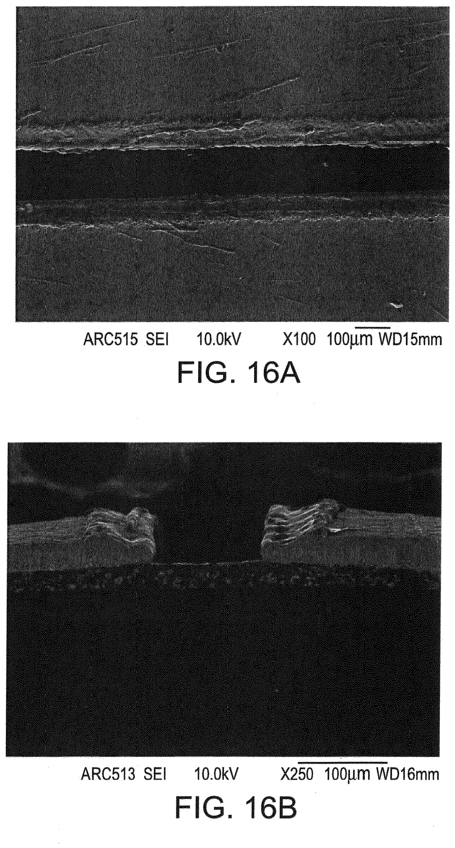

The SEM photographs 16A and 16B are taken from a top view and cross sectional view of samples cut from high speed tests on the 35 µm Cu material at 1.2 m/s processed under the same repetition rate of 45 kHz and 50% power. They are processed in the presence of 1 bar of assist air from a 1 mm diameter nozzle around the laser beam. The assist gas is blown to the work area by a nozzle through which the laser beam is also delivered. The measured width of recast on one side is 77 µm and on the other side, the width is 72 µm. The width/kerf of the ablated line is 140 um. The height of recast along the edge is only 15 µm (approximately 40 µm including 25 µm of copper thickness.) Figure 16B illustrates no PET damage and no copper delamination. These are very successful results obtained both on 25 µm thick and on 35 µm thick copper laminates. These results demonstrate that superior patterns or ablation results occur at faster speeds of at least up to 1.5 m/s (or 1.2 m/s for thicker material) without the need for more than 50% of the available power. It is expected for workstations which can deliver significantly faster speeds, higher power usage can be employed if the same 2:1 imaging is maintained. This was also obtained previously by using a scanning system.

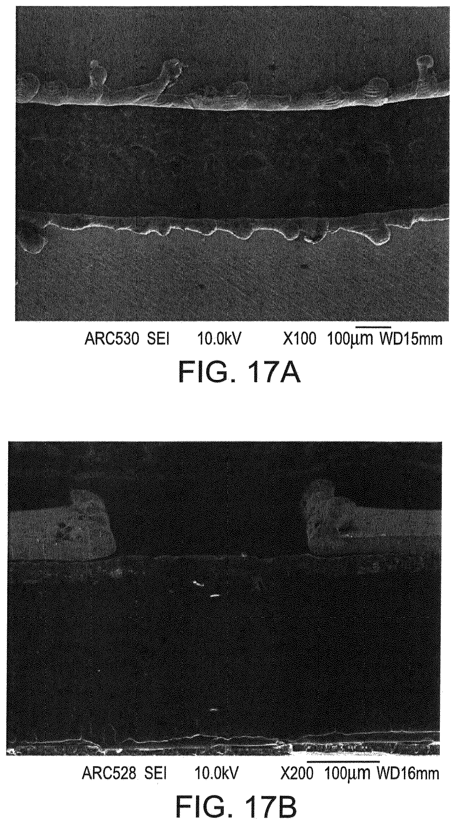

Figures 17A and 17B are SEM images from the cut samples in the contours of the panels similar to the one presented in Figure 14A. The panel was prepared on 25 µm thick copper and processed at 450 mm/s, a repetition rate of 22.5 kHz, at 35% power, 1 mm nozzle and 0.5 bar of argon assist gas. Some burning on the adhesive was visible. This results in the formation of holes on the surface of the adhesive but the cross sectional view (Figure 17B) illustrates no PET damage. The width of the recast is measured on one side as 46 µm and on the other side as 36 µm. The ablated width/kerf is 300 µm. A wider line ablated in the curved lines is observed than in the straight line. A relation between the power to the velocity was identified such that when the velocity decreases in the contours the power will also decrease as a nonlinear function of the velocity. Application of this relation enables ablation without PET damage despite reduced speed in this area. The measured height of recast on one side was 21 µm and on the other side 30 µm, both well within acceptable limits.

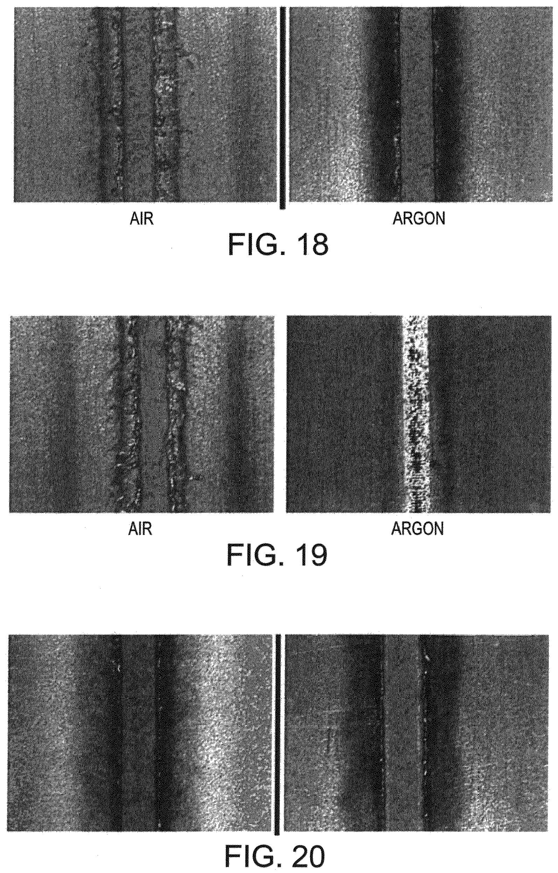

It was expected and demonstrated that the power, frequency, and process speed (hence spot overlap) had an effect on the quality of the laser ablation. However, it was discovered that the assist gas played a very significant role in the laser ablation process and affected both the absorption of the laser at the foil surface and the nature of the recast material. Figure 18 presents one case of the effect of changing the assist gas from air to argon while keeping all other process parameters fixed. It is clear that the nature of the deposition and oxidation is significantly different between the two gases.

Another case that clearly demonstrates the effect of assist gas on absorption of the laser by copper is shown in Figure 19. For the same process settings, the laser is able to cut through the foil when assisted with compressed air while the cut made with argon as assist gas only marks the surface. The most likely explanation for this effect is that heating the copper in the presence of oxygen allows for an oxide layer to grow on the surface. The oxide layer is more absorptive of the laser than the bare copper. And so, the oxide layer assists in improving the coupling of the laser energy with the material. Laser ablation while using argon as the assist gas helps to shield copper foil from oxygen in the air thereby preventing oxide growth on the surface and resulting in lower absorption of the laser energy.

The results of preferred settings for average speeds to pattern a photovoltaic cell with the workstation described herein are presented in Figure 20. These laser process settings that minimize substrate damage and recast height were found when using argon as an assist gas and with 35% of maximum power. The micrograph on the left illustrates a 35 µm thick foil. And the micrograph on the right illustrates a 25 µm thick foil.

### EVALUATIONS USING ROUND FIBERS

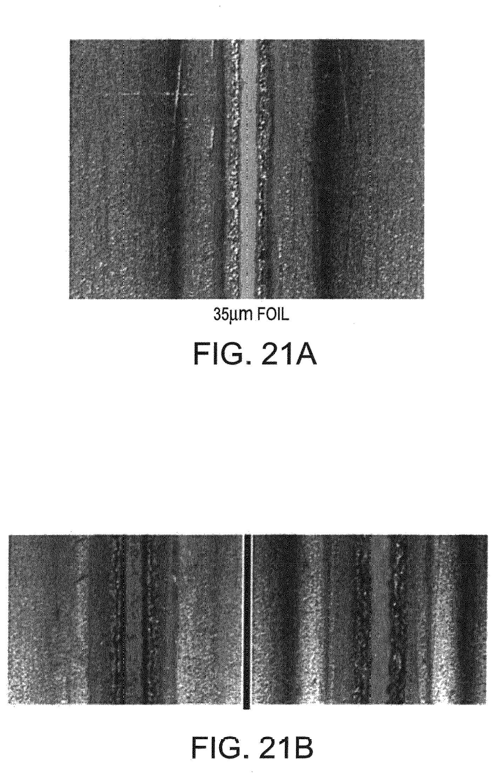

Various evaluations based upon the previously described investigations using square fibers, were performed after replacing the square fiber with a 400 micron round fiber. A first set of trials was performed to evaluate how the round fiber results compared with the square fiber results when using the settings that produced the best results with the square fiber. See Table 3 below, for the process parameters used for the high speed tests. Similar results were achieved at the same process settings with the round fiber but at higher pulse frequencies, hence lower peak powers, due to the smaller spot size. On the 35 microns thick copper, very good results were obtained at 1200 mm/s as was the case with the square fiber. Figure 21A presents a micrograph image of the results of the ablation of the 35 micron laminated foil when using the following settings with the round fiber. Similar settings are used except for a 55 kHz of repetition rate instead of 45 kHz. This is due to a smaller spot size that needs a lower pulse energy for the same fluence. Other successful cases when using the round fiber are with lower speeds of 450 mm/s in which the contours of the panel can be ablated with good quality as shown in Figure 21B. These are two different settings for all parameters except for the linear speed. It is interesting that the best results at around 450 mm/s were obtained when using oxygen as an assist gas.

**Table 3 - Process Parameters Used for High Speed Tests With Round Fibers**

| Parameter | 35 µm | Units |
|---|---|---|
| Process Speed | 1200 | [W] |
| Laser Power | 50 | [%] |
| Laser Power | 375 | [W] |
| Frequency | 55 | [kHz] |
| Pulse Energy | 6.82 | [mJ] |
| Laser Spot Area | 3.14e-4 | [cm²] |
| Fluence | 21.70 | [J/cm²] |
| Spot Overlap | 90.51 | [%] |
| Assist Nozzle Dia. | 1 | [mm] |
| Assist Gas | Air | |
| Assist Gas Pressure | 1 | [bar] |

The single panels patterned by the square fiber (presented in Figure 14) were also made with the settings at a speed of 450 mm/s using the 400 µm round fiber. The results showed comparable height of the recast material and comparable deposited areas as with the square fiber. The overall main difference in the results of the ablation trials with the round fiber when compared with the square fiber is the kerf width which is smaller. This is clear as the ablation spot is smaller as well. It was expected that additional difficulties would be observed at the contours with the square fiber as compared to the round one but they both worked satisfactory at the contours (see Figures 17A and 17B). A need exists to keep the kerf width as large as possible for the same processing speed. As expected by its larger delivery fiber, the square fiber consistently produces a wider kerf as compared to the round fiber. The square fiber is therefore generally preferred for use in a production system with this laser type.

Also, in order to assess the quality of ablated lines, electrical isolation tests were performed on single panels made with the square fiber. These are standard electrical tests to determine if the ablated line can isolate separated zones also under high voltages of 3000 volts. Chemically etched panels were prepared with 100, 150 and 200 micrometer gaps, i.e. (kerf widths) to compare their isolation results with the laser etched panels. Another set of control samples was prepared by chemically etching a uniform regular gap of 1 mm for the tests. All panels with the 1 mm gap passed the 3 kV isolation test without problems. All the chemically etched panels with the 100 micron gap failed at around 1 kV or at lower voltages. The results were mixed for chemically etched panels with gaps of 150 and 200 micron. However, on average 60% of the noted chemically etched panels failed at voltages between 1 and 2 kV. The laser etched (ablated) panels tested under the same conditions failed at 50%. The width (gap) for the laser ablated panels was measured as between 180 µm and 280 µm depending on the curvature of the panel. Although these results are as good if not better results than wet etched samples, these isolation tests demonstrate that the kerf width was not sufficiently wide. The chemically etched control samples in addition to the laser ablated panels demonstrate that there is a need to provide wider kerfs in order to have a meaningful production capable system.

All of these evaluations were performed using a 2:1 imaging of the previously noted 460 micron and 400 micron fibers. It was also evident that at most only 50% of the average power of 750 W was used even for high speed ablation. Therefore it is recommended to use 1:1 imaging systems with higher average power to ablate wider kerfs. The kerf widths are dependent on the linear speed of the laser ablation. For example on the thicker foil of 35 micron when ablated using the square fiber, the measured values of width are from 140 microns at a high speed of 1200 mm/s, to 300 microns at a speed of 400 mm/s. At 400 mm/s, each laser pulse has 3 times "residence time" as compared with the same at 1200 mm/s thereby producing a twice wider ablated area. When using a 1:1 imaging the spot size doubles hence raising the ablated width significantly if the average power is raised accordingly.

The results of the trials described herein clearly demonstrate that very good results are obtained at high speeds (1.2 to 1.5 m/s) rather than at low speeds. A commercial system for laser ablation of the copper foils using this laser can be provided. And, a workstation capable of moving the heavy equipment in both directions at high speed can be provided. Cost calculations indicate that a commercial laser workstation built based on these results is capable of patterning photovoltaic backsheets at a much lower total cost than current chemical etching processes.

Many other benefits will no doubt become apparent from future application and development of this technology.

Additional details as to assemblies, components, and processes for forming conductive connections, contacts and particularly for photovoltaic cells are provided in US Patent 7,759,158 to Bachrach; and US Patents 5,468,652 and 5,951,786 both to Gee.

All patents, applications, and articles noted herein are hereby incorporated by reference in their entirety.

It will be understood that any one or more feature or component of one embodiment described herein can be combined with one or more other features or components of another embodiment. Thus, the present subject matter includes any and all combinations of components or features of the embodiments described herein.

As described hereinabove, the present subject matter solves many problems associated with previous type devices. However, it will be appreciated that various changes in the details, materials and arrangements of parts, which have been herein described and illustrated in order to explain the nature of the subject matter, may be made by those skilled in the art without departing from the principle and scope of the subject matter, as expressed in the appended claims.

In the following, further features, characteristics and advantages of the invention will be described by means of items:
Item 1. A method of forming a flexible circuit using a laser, the method comprising:
   providing a metal foil laminate, wherein a metal foil is laminated on a carrier;
   patterning the metal foil using a laser to form an electric circuit without damaging the carrier.
Item 2. The method of item 1, wherein the metal foil laminate further includes an adhesive, and the metal foil is laminated on the carrier through the adhesive.
Item 3. The method of item 2, wherein the adhesive is a two stage cure adhesive.
Item 4. The method of item 3, further comprising:
   conducting stage A curing of the adhesive prior to patterning;
   removing excess metal foil after the patterning step; and
   conducting stage B curing of the adhesive.
Item 5. The method of any one of items 1-4 wherein the laser is selected from an IR laser, a UV laser, and a green laser.
Item 6. The method of any one of items 1-5 wherein patterning includes forming a metal-free area by ablation of the metal foil using the laser.
Item 7. The method of item 6 wherein the metal-free area defines a minimum kerf width.
Item 8. The method of item 7 wherein the minimum kerf width is 50 micrometer.
Item 9. A method of forming a flexible circuit using a laser, the method comprising:
   providing a metal foil laminate, wherein a metal foil is laminated on a carrier;
   selecting a laser and a set of operating parameters such that the patterning process does not cause damage to the carrier;
   patterning the metal foil using the selected laser to create a pattern suitable for forming an electric circuit with a minimum kerf width.
Item 10. The method of item 9, wherein the type of laser is selected from an IR laser, UV laser, and a green laser.
Item 11. The method of item 9 wherein the set of operating parameters include beam size, bean shape, beam intensity profile, wavelength, power, pulse energy, frequency, speed and combinations thereof.
Item 12. The method of item 9 wherein the carrier is a polymeric material, the method further comprising:
   prior to patterning the metal foil, preventing damage to the polymeric carrier.
Item 13. The method of item 12 wherein the metal foil is laminated on the carrier by an adhesive and preventing damage to the polymeric carrier is performed by incorporating at least one additive into the adhesive which reduce transmission of laser light into the carrier.
Item 14. The method of item 13 wherein the additive reflects laser light.
Item 15. The method of item 14 wherein the additive is selected from the group consisting of inorganic additives and organic additives.
Item 16. The method of item 12 wherein preventing damage to the polymeric carrier is performed by depositing a metal layer on the carrier such that the metal layer is disposed between the metal foil and the carrier.
Item 17. The method of item 16 wherein the metal layer is aluminum.
Item 18. The method of item 12 wherein the laser emits light having a wavelength in a green range, and preventing damage to the carrier is performed by reflecting at least a portion of the emitted light away from the carrier.
Item 19. The method of item 9 wherein the minimum kerf width is 50 micrometers.
Item 20. The method of any one of items 1-19, wherein multiple electrodes are to be formed at designated locations on the electric circuit, the method further comprising:
   depositing an interlayer dielectric layer on the electric circuit except the designated locations for electrodes; and
   depositing a protective and electrical conductive material at the designated locations for electrodes.
Item 21. The method of item 20 wherein the interlayer dielectric layer is a UV curable dielectric ink.
Item 22. The method of item 20 wherein depositing the interlayer dielectric layer is performed by a screen printing process.
Item 23. The method of any one of items 20-22 further comprising:
   after depositing the interlayer dielectric layer, curing the interlayer dielectric layer.
Item 24. The method of item 23 wherein curing the interlayer dielectric layer is performed by exposing the interlayer dielectric layer to UV light.
Item 25. The method of any one of items 20-24 wherein the protective material is silver.
Item 26. The method of any one of items 1-25 wherein the metal foil is selected from the group consisting of copper foil, aluminum foil, and combinations thereof.
Item 27. The method of item 26 wherein the metal foil is aluminum foil and the aluminum foil includes a naturally occurring oxide layer, the method further comprising:
   removing the naturally occurring oxide layer at predefined areas;
   depositing another metal layer at the predefined areas from which at least a portion of the naturally occurring oxide layer has been removed.
Item 28. The method of item 26 wherein the metal foil is aluminum foil with a layer of copper covering at least a portion of the aluminum.
Item 29. The method of item 26 wherein the metal foil is copper foil, the method further comprising:
   protecting the copper foil by depositing a layer of silver or organic solderability preservative on the copper foil.
Item 30. The method of item 26 wherein the metal foil is aluminum foil, the method further
   comprising:
   protecting the aluminum foil by depositing a layer of copper on the aluminum foil;
   protecting the copper layer by depositing a layer of silver or organic solderability preservative on the copper layer.
Item 31. The method of any one of items 29-30 wherein protecting is performed prior to patterning.
Item 32. The method of any one of items 29-30 wherein protecting is performed after patterning.
Item 33. The method of any one of items 1-32 wherein patterning is performed at a speed of at least 400 mm/s.
Item 34. The method of item 33 wherein patterning is performed at a speed of at least 1,000 mm/s.
Item 35. The method of item 34 wherein patterning is performed at a speed of at least 2,000 mm/s.
Item 36. A photovoltaic conductive backsheet formed from any one of the methods of items 1-35.
Item 37. A photovoltaic module, comprising:
   a c-Si cell; and
   a backsheet, wherein the backsheet is formed from any one of the methods of items 1-36.
Item 38. A system configured for forming a flexible circuit from a metal foil laminate using a laser, the system comprising:
   a laser source;
   a roll of metal foil laminate wherein a metal foil is disposed on a carrier, and the laser source is configured to operate at a set of operating parameters including beam size, beam shape, beam intensity profile, wavelength, power, pulse energy, frequency, speed and combinations thereof so that the circuit is formed at a speed of at least 400 mm/s and the carrier remains intact through the formation of the flexible circuit.

## Claims

1. A sheet assembly comprising:
a carrier substrate (210);
a conductive metal layer (220); and
an adhesive layer (230) configured to bond the conductive metal layer (220) with the carrier substrate (210).

2. The sheet assembly of claim 1, wherein the adhesive layer comprises one or more additives, particularly wherein the one or more additives exhibit light reflecting or light blocking properties.

3. The sheet assembly of claim 1 or 2, wherein the one or more additives are inorganic particulates.

4. The sheet assembly of any one of the preceding claims, wherein the one or more additives are organic materials.

5. The sheet assembly of any one of the preceding claims, wherein the adhesive layer (230) comprises a two stage adhesive.

6. The sheet assembly of any one of the preceding claims, further comprising a coating provided on one or both sides of the carrier substrate.

7. The sheet assembly of any one of the preceding claims, wherein the conductive metal layer (220) is a patterned conductive metal layer (220).

8. A sheet assembly comprising:
a carrier substrate (210);
a conductive metal layer (220);
an adhesive layer (230) configured to bond the conductive metal layer (220) with the carrier substrate (210); and
a metal layer deposited on the carrier substrate (210).

9. A photovoltaic module comprising:
a C-Si cell; and
a sheet assembly according to any one of the preceding claims.

10. A system configured for forming a flexible circuit from a metal foil laminate using a laser, the system comprising:
a laser source;
a roll of metal foil laminate wherein a metal foil is disposed on a carrier, and the laser source is configured to operate at a set of operating parameters including beam size, beam shape, beam intensity profile, wavelength, power, pulse energy, frequency, speed and combinations thereof so that the circuit is formed at a speed of at least 400 mm/s and the carrier remains intact through the formation of the flexible circuit.

11. The system of claim 10, wherein there is a coating on a backside of the carrier.

12. The system of claim 10, wherein laser beams are "top hat" and Gaussian.

13. The system of claim 10, wherein the substrate is carrier is polymeric.

14. The system of claim 10, wherein the metal foil laminate is copper.

15. The system of claim 12, wherein the beams are square or round.
